# EUROPEAN PATENT APPLICATION

(11) **EP 4 539 649 A1**
(43) Date of publication of application: **16.04.2025**
(21) Application number: 24175040.5
(22) Date of filing: 09.05.2024
(51) Int. Cl.: H10N 50/10, H10B 61/00

(54) **MAGNETIC TUNNELING JUNCTION DEVICE AND MEMORY DEVICE INCLUDING THE SAME**

(30) Priority: 12.10.2023 KR 20230136216
(71) Applicant: Samsung Electronics Co., Ltd., Suwon-si, Gyeonggi-do 16677 (KR)
(72) Inventor: KIM, Kwangseok, 16678, Suwon-si (KR); KIM, Kiwoong, 16677, Suwon-si (KR); PARK, Seonggeon, 16677, Suwon-si (KR)
(74) Representative: Elkington and Fife LLP

(57) **Abstract**

Disclosed is a magnetic tunnel junction device (100) including a pinned layer (103) on a seed layer (102), a free layer (105) facing the pinned layer, and a tunnel barrier layer (104) between the pinned layer and the free layer, wherein the seed layer includes a first seed layer (102a) and a second seed layer (102b), one of the seed layers including rhenium (Re) and the other including ruthenium (Ru). Alternatively, a single seed layer comprising a Re alloy having a hexagonal close-packed (HCP) crystal structure can be used.

## Description

### FIELD OF THE INVENTION

The disclosure relates to magnetic tunneling junction devices and memory devices including the magnetic tunneling junction devices.

### BACKGROUND OF THE INVENTION

A magnetic memory device such as magnetic random-access memory (MRAM) stores data by using a change in the resistance of a magnetic tunneling junction device. The resistance of the magnetic tunneling junction device varies with the magnetization direction of a free layer. For example, when the magnetization direction of the free layer is the same as the magnetization direction of a pinned layer, the magnetic tunneling junction device may have a low resistance, and when the magnetization direction of the free layer is opposite to the magnetization direction of a pinned layer, the magnetic tunneling junction device may have a high resistance. When this characteristic is used in a memory device, for example, the magnetic tunneling junction device having a low resistance may correspond to data '0' and the magnetic tunneling junction device having a high resistance may correspond to data '1'.

In a process of manufacturing a memory device including such a magnetic tunnel junction device, it is advantageous to prevent or minimize deterioration of the magnetic tunnel junction device due to high temperature heat treatment.

### SUMMARY OF THE INVENTION

Some example embodiments of the disclosure provide magnetic tunneling junction devices capable of maintaining performance even during a relatively high temperature heat treatment process.

Some example embodiments of the disclosure provide memory devices including the magnetic tunneling junction devices described above.

Additional aspects will be set forth in part in the description which follows and, in part, will be apparent from the description, or may be learned by practice of the presented example embodiments of the disclosure.

According to an example embodiment, a magnetic tunneling junction device includes a seed layer, a pinned layer on the seed layer, a free layer facing the pinned layer, and a tunnel barrier layer between the pinned layer and the free layer, wherein the seed layer includes a first seed layer and a second seed layer and the second seed layer is between the first seed layer and the pinned layer, and one of the first seed layer and the second seed layer includes rhenium (Re) and the other of the first seed layer and the second seed layer includes ruthenium (Ru).

Proposed is the concept of a MTJ using a Re seed layer. The proposed invention proposes use of a new material, Re seed layer, which is more stable at high temperatures than Ru, and is not affected by the properties of pinned layer materials such as CoPt. In particular, this material has magnetic characteristics similar to high-temperature deposited Ru even if it is deposited at room temperature, and is expected to help simplify the configuration of MTJ deposition equipment for MRAM. By using Re seed, which is a more stable material candidate at high temperature and has a higher melting point, it is possible to secure stable TMR and magnetic characteristics even after high temperature anneal, in addition to magnetic characteristics equivalent to conventional MTJ.

Embodiments proposed a structure using Re as a seed layer necessary to form a pinned layer material.

Some embodiments proposed a seed layer formed as Ru/Re or Re/Ru by forming a bilayer structure with an existing Ru.

A total thickness of the seed layer may be 1 nm or more and 10 nm or less.

The first seed layer may include rhenium (Re) and the second seed layer may include ruthenium (Ru).

A thickness of the first seed layer is 50 % or more of the total thickness of the seed layer.

The first seed layer includes ruthenium (Ru) and the second seed layer may include rhenium (Re).

A thickness of the second seed layer may be 50 % or more of a total thickness of the seed layer.

The seed layer may further include a third seed layer between the second seed layer and the pinned layer.

The first seed layer may include rhenium (Re), the second seed layer includes ruthenium (Ru), and the third seed layer includes rhenium (Re).

A sum of a thickness of the first seed layer and a thickness of the third seed layer may be 50 % or more of a total thickness of the seed layer.

The first seed layer may include ruthenium (Ru), the second seed layer includes rhenium (Re), and the third seed layer may include ruthenium (Ru).

A thickness of the second seed layer may be 50 % or more of a total thickness of the seed layer.

The pinned layer may include a first ferromagnetic layer adjacent to the seed layer, a second ferromagnetic layer adjacent to the tunnel barrier layer, and a synthetic antiferromagnet (SAF) coupling layer provided between the first ferromagnetic layer and the second ferromagnetic layer, and magnetization directions of the first ferromagnetic layer and the second ferromagnetic layer may be opposite to each other.

The SAF coupling layer may include conductive metal.

The magnetic tunnel junction device may further include a polarization enhancing layer between the pinned layer and the tunnel barrier layer and including a ferromagnetic material.

According to an example embodiment, a magnetic tunneling junction device includes a seed layer, a pinned layer on the seed layer, a free layer facing the pinned layer, a tunnel barrier layer between the pinned layer and the free layer, and wherein the seed layer is a single layer including rhenium (Re) alloy having a hexagonal close-packed (HCP) structure.

The rhenium alloy may include an alloy of rhenium (Re) and at least one metal among ruthenium (Ru), platinum (Pt), gold (Au), iridium (Ir), or cobalt (Co).

A ratio of rhenium (Re) in the seed layer may be 50 at% or more and a ratio of the at least one metal other than rhenium (Re) is 50 at% or less.

According to an example embodiment, a plurality of memory cells each includes a magnetic tunnel junction device and a switching device connected to the magnetic tunnel junction device, wherein the magnetic tunnel junction device includes a seed layer, a pinned layer on the seed layer, a free layer facing the pinned layer, and a tunnel barrier layer between the pinned layer and the free layer, wherein the seed layer includes a first seed layer and a second seed layer between the first seed layer and the pinned layer, and one of the first seed layer and the second seed layer includes rhenium (Re) and the other of the first seed layer and the second seed layer includes ruthenium (Ru).

The memory device may further include a passivation layer between the plurality of memory cells.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a cross-sectional view illustrating a schematic structure of a magnetic tunneling junction device according to an example embodiment;
FIG. 2A shows a surface of a seed layer including only ruthenium after heat treatment, FIG. 2B shows a surface of a seed layer including only rhenium after heat treatment, FIG. 2C shows a surface of a pinned layer provided on the seed layer including only ruthenium after heat treatment, and FIG. 2D shows a surface of a pinned layer provided on a seed layer of a double layer structure including rhenium/ruthenium after heat treatment;
FIG. 3A is a cross-sectional view of a seed layer including only ruthenium and a pinned layer provided thereon, FIG. 3B is an enlarged cross-sectional view of a part of the seed layer including only ruthenium, and FIG. 3C shows a diffraction image of the seed layer including only ruthenium;
FIG. 4A is a cross-sectional view of a seed layer of a double layer structure including rhenium/ruthenium and a pinned layer provided thereon, FIG. 4B is an enlarged cross-sectional view of a part of a rhenium seed layer, FIG. 4C is an enlarged cross-sectional view of a part of a ruthenium seed layer, FIG. 4D shows a diffraction image of the rhenium seed layer, and FIG. 4E shows a diffraction image of the ruthenium seed layer;
FIGS. 5A and 5B show a comparison of a resistance-area product (RA) and a tunnel magnetoresistance ratio (TMR) of a magnetic tunnel junction device according to the configuration of various seed layers;
FIG. 6 is a graph for comparing a Kerr rotation angle with respect to an external magnetic field in a pinned layer provided on a seed layer and including only ruthenium with a Kerr rotation angle with respect to an external magnetic field in a pinned layer provided on a seed layer and including only rhenium;
FIG. 7 is a cross-sectional view illustrating a schematic structure of a magnetic tunneling junction device according to another example embodiment;
FIG. 8 is a cross-sectional view illustrating a schematic structure of a magnetic tunneling junction device according to another example embodiment;
FIG. 9 is a cross-sectional view illustrating a schematic structure of a magnetic tunneling junction device according to another example embodiment;
FIG. 10 is a cross-sectional view illustrating a schematic structure of a magnetic tunneling junction device according to another example embodiment;
FIG. 11 schematically shows a structure of a memory cell including a magnetic tunneling junction device according to an example embodiment;
FIG. 12 is a perspective view illustrating an arrangement structure of a magnetic tunnel junction device and a switching device in the memory cell shown in FIG. 11;
FIG. 13 is a circuit diagram schematically illustrating a configuration of a memory device including a plurality of memory cells;
FIG. 14 schematically shows a cross-sectional structure of a plurality of memory cells of the memory device shown in FIG. 13; and
FIG. 15 is a conceptual diagram schematically illustrating a device architecture that may be applied to an electronic device according to an example embodiment.

### DETAILED DESCRIPTION

Reference will now be made in detail to some example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the present example embodiments are merely described below, by referring to the figures, to explain aspects. As used herein, the term "and/or" includes any and all combinations of one or more of the associated listed items. Expressions such as "at least one of," or "at least one among" when preceding a list of elements, modify the entire list of elements and do not modify the individual elements of the list.

Hereinafter, with reference to the accompanying drawings, a magnetic tunneling junction device and a memory device including the magnetic tunneling junction device will be described in detail. Like reference numerals refer to like elements throughout, and in the drawings, sizes of elements may be exaggerated for clarity and convenience of explanation. The example embodiments described below are merely examples, and various modifications may be possible from the disclosed example embodiments.

In a layer structure described below, an expression "above" or "on" may include not only "immediately on in a contact manner" but also "on in a non-contact manner". An expression used in the singular encompasses the expression of the plural, unless it has a clearly different meaning in the context. It will be further understood that the terms "comprises" and/or "comprising" used herein specify the presence of stated features or elements, but do not preclude the presence or addition of one or more other features or elements.

The use of "the" and other demonstratives similar thereto may correspond to both a singular form and a plural form. Unless the order of operations of a method according to the disclosure is explicitly mentioned or described otherwise, the operations may be performed in a proper order. The disclosure is not limited to the order the operations are mentioned.

The term used in the example embodiments such as "unit" or "module" indicates a unit for processing at least one function or operation, and may be implemented in hardware or software, or in a combination of hardware and software.

The connecting lines, or connectors shown in the various figures presented are intended to represent functional relationships and/or physical or logical couplings between the various elements. It should be noted that many alternative or additional functional relationships, physical connections or logical connections may be present in a practical device.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

The use of any and all examples, or language provided herein, is intended merely to better illuminate the disclosure and does not pose a limitation on the scope of the disclosure unless otherwise claimed.

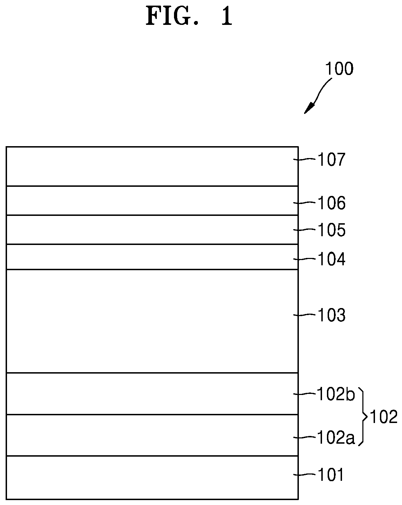

FIG. 1 is a cross-sectional view illustrating a schematic structure of a magnetic tunneling junction device 100 according to an example embodiment. Referring to FIG. 1, the magnetic tunneling junction device 100 may include a seed layer 102, a pinned layer 103 provided on the seed layer 102, a tunnel barrier layer 104 provided on the pinned layer 103, and a free layer 105 provided on the tunnel barrier layer 104. The expression "provided on" is just for convenience of description and does not necessarily mean a vertical relationship. In other words, the pinned layer 103 and the free layer 105 may be disposed to face each other, and the tunnel barrier layer 104 may be disposed between the pinned layer 103 and the free layer 105. The magnetic tunneling junction device 100 according to an example embodiment may further include a capping oxide layer 106 provided on the free layer 105 and a capping metal layer 107 provided on the capping oxide layer 106.

The pinned layer 103 and the free layer 105 may include a ferromagnetic metal material having magnetism. For example, the pinned layer 103 and the free layer 105 may include at least one of iron (Fe), cobalt (Co), nickel (Ni), manganese (Mn), a Fe-including alloy, a Co-including alloy, a Ni-including alloy, a Mn-including alloy, a Ru-including alloy, or a Heusler alloy. The pinned layer 103 may have a pinned magnetization direction. The free layer 105 may have a variable magnetization direction. The magnetic tunnel junction device 100 may have a low resistance when magnetization directions of the pinned layer 103 and the free layer 105 are the same, and may have a high resistance when the magnetization directions thereof are opposite to each other. This phenomenon is called tunneling magnetoresistance (TMR). The magnetic tunneling junction device 100 may be used in a memory device by applying this TMR phenomenon.

According to an example embodiment, the pinned layer 103 and the free layer 105 may have high perpendicular magnetic anisotropy (PMA), in particular, interface perpendicular magnetic anisotropy (IPMA). In other words, a PMA energy of each of the pinned layer 103 and the free layer 105 may exceed out-of-plane demagnetization energy. In this case, a magnetic moment of each of the pinned layer 103 and the free layer 105 may be stabilized in a direction perpendicular to a layer direction. The magnetic tunnel junction device 100 may be applied to spin transfer torque-magnetic RAM (STT-MRAM) or spin-orbit torque (SOT)-MRAM.

In order to improve an operation speed of the memory device using the magnetic tunnel junction device 100, the free layer 105 may have a low saturation magnetization (Ms). In order to lower the saturation magnetization Ms of the free layer 105, the free layer 105 may be further doped with a non-magnetic metal element. For example, the free layer 105 may be doped with at least one non-magnetic metal among calcium (Ca), scandium (Sc), yttrium (Y), magnesium (Mg), strontium (Sr), barium (Ba), zirconium (Zr), beryllium (Be), titanium (Ti), hafnium (Hf), vanadium (V), zinc (Zn), niobium (Nb), manganese (Mn), aluminum (Al), chromium (Cr), lithium (Li), cadmium (Cd), lead (Pb), indium (In), gallium (Ga), or tantalum (Ta). The non-magnetic metal doped into the free layer 105 may have an oxygen affinity higher than that of the ferromagnetic metal material of the free layer 105.

In addition, when desired, the free layer 105 may have a multilayer structure including two or more layers of a layer including only a ferromagnetic metal material and a layer doped with a non-magnetic metal. Through the material and structure of the free layer 105, diffusion of oxygen or metal elements may be reduced or prevented at an interface with the tunnel barrier layer 104.

The tunnel barrier layer 104 may serve to provide a magnetic tunneling junction between the pinned layer 103 and the free layer 105. The tunnel barrier layer 104 may include crystalline metal oxide. For example, the tunnel barrier layer 104 may include MgO, MgAl₂O₄, or MgTiOₓ.

Meanwhile, the magnetic tunnel junction device 100 may further include a lower electrode 101. The lower electrode 101 may include a conductive material to apply current to the magnetic tunnel junction device 100. The lower electrode 101 may include low resistance metal or metal nitride. For example, the lower electrode 101 may include TiN or TaN. The lower electrode 101 may be a part of the magnetic tunnel junction device 100, but may also be a part of a memory device including the magnetic tunnel junction device 100.

TiN or TaN used as the lower electrode 101 has a body centered cubic lattice (BCC) structure. On the other hand, crystals of the ferromagnetic metal material used in the pinned layer 103 provided on the lower electrode 101 mainly have a hexagonal close-packed (HCP) structure with a crystal orientation of (0001). Therefore, when the pinned layer 103 is formed directly on the lower electrode 101, the crystal quality of the pinned layer 103 may deteriorate. Thus, the seed layer 102 may be disposed between the lower electrode 101 and the pinned layer 103 to prevent or minimize the deterioration of the crystal quality of the pinned layer 103. In other words, the seed layer 102 may be first formed on the lower electrode 101, and the pinned layer 103 may be formed on the seed layer 102.

The seed layer 102 may include a material on which crystals of the HCP structure may grow. In addition, during high temperature heat treatment in a manufacturing process of the memory device including the magnetic tunnel junction device 100, the seed layer 102 may have a material and structure capable of preventing or minimizing deterioration of a texture of the seed layer 102 or deterioration of characteristics of the pinned layer 103 due to intermixing between the seed layer 102 and the pinned layer 103, etc. To this end, the seed layer 102 may include rhenium (Re). Rhenium (Re) has a very high melting point of approximately 3186 °C and also has an HCP crystal structure. Therefore, rhenium (Re) may maintain the HCP structure well even when annealed at a temperature of about 400 °C for about 5 hours.

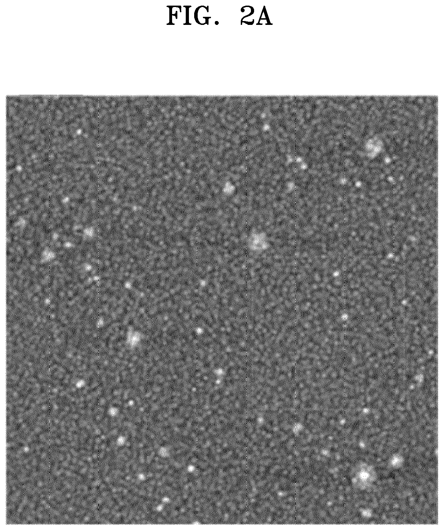

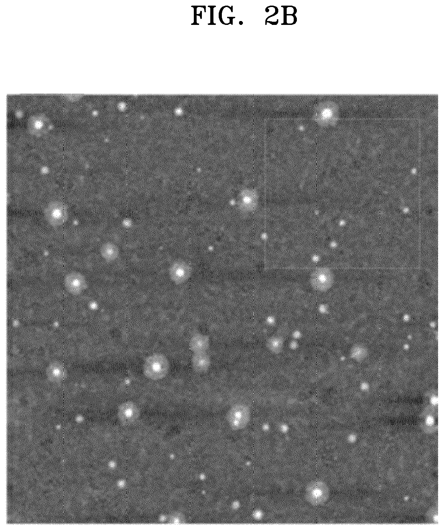

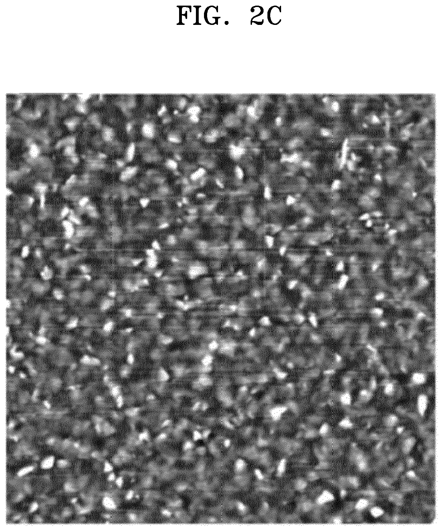

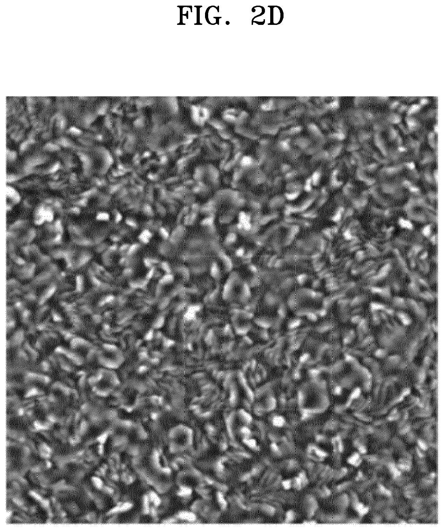

FIG. 2A shows a surface of a seed layer including only ruthenium (Ru) after heat treatment, FIG. 2B shows a surface of a seed layer including only rhenium (Re) after heat treatment, FIG. 2C shows a surface of a pinned layer provided on the seed layer including only ruthenium (Ru) after heat treatment, and FIG. 2D shows a surface of a pinned layer provided on a seed layer of a multi-layer structure (e.g., a double layer structure) including rhenium (Re)/ruthenium (Ru) after heat treatment. In FIGS. 2A to 2D, heat treatment was performed at a temperature of 400 °C for 5 hours. Also, in FIGS. 2C and 2D, CoPtCr was used as the pinned layer.

Referring to FIGS. 2A and 2B, it may be seen that a surface roughness of the seed layer including only rhenium (Re) after heat treatment is lower than a surface roughness of the seed layer including only ruthenium (Ru) after heat treatment. For example, a root mean square (RMS) surface roughness of the seed layer including only ruthenium (Ru) after heat treatment is about 0.324 nm, and an RMS surface roughness of the seed layer including only rhenium (Re) after heat treatment is about 0.169 nm. Also, referring to FIGS. 2C and 2D, it may be seen that a surface roughness of the pinned layer provided on the seed layer of the double layer structure including rhenium (Re)/ruthenium (Ru) after heat treatment is lower than a surface roughness of the pinned layer provided on the seed layer including only ruthenium (Ru) after heat treatment. For example, an RMS surface roughness of the pinned layer provided on the seed layer including only ruthenium (Ru) after heat treatment is 1.04 nm, and an RMS surface roughness of the pinned layer provided on the seed layer of the double layer structure including rhenium (Re)/ruthenium (Ru) after heat treatment is 0.763 nm.

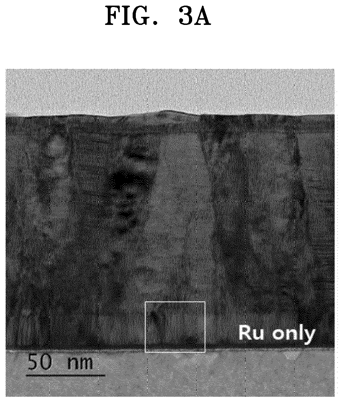

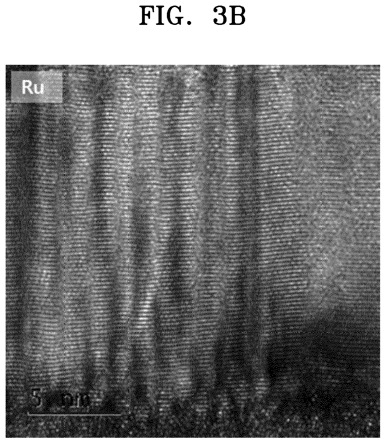

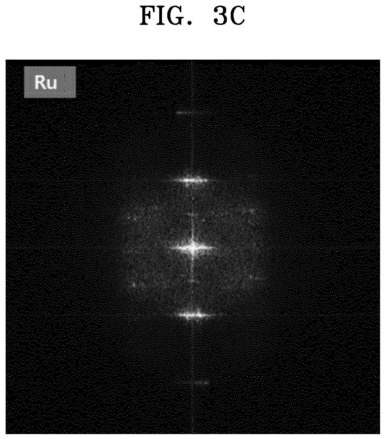

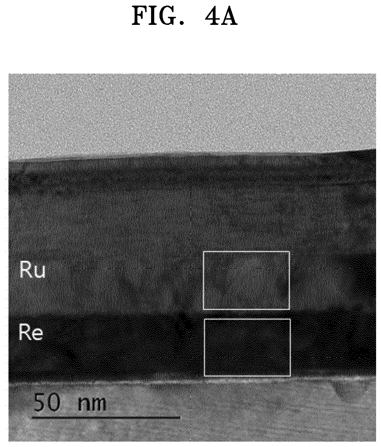

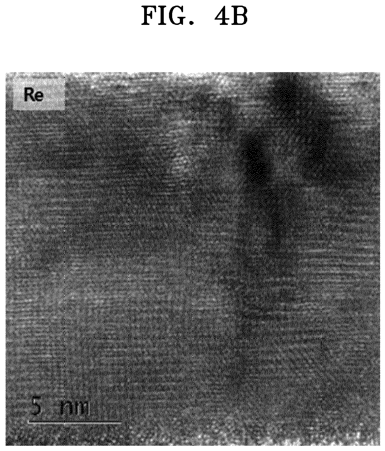

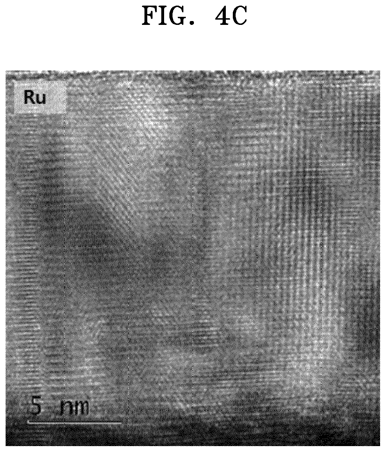

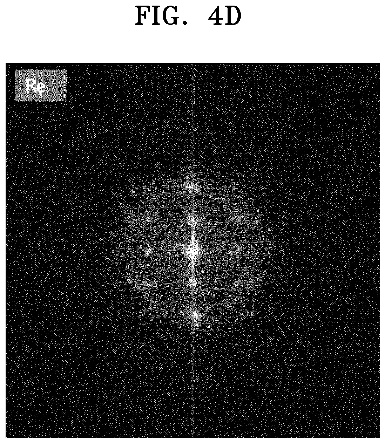

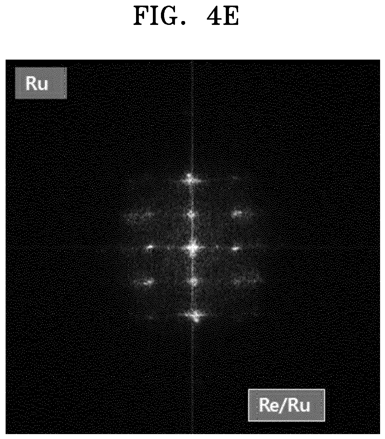

FIG. 3A is a cross-sectional view of a seed layer including only ruthenium (Ru) and a pinned layer provided thereon, FIG. 3B is an enlarged cross-sectional view of a part of the seed layer including only ruthenium (Ru), and FIG. 3C shows a diffraction image of the seed layer including only ruthenium (Ru). In addition, FIG. 4A is a cross-sectional view of a seed layer of a double layer structure including rhenium (Re)/ruthenium (Ru) and a pinned layer provided thereon, FIG. 4B is an enlarged cross-sectional view of a part of a rhenium (Re) seed layer, FIG. 4C is an enlarged cross-sectional view of a part of a ruthenium (Ru) seed layer, FIG. 4D shows a diffraction image of the rhenium (Re) seed layer, and FIG. 4E shows a diffraction image of the ruthenium (Ru) seed layer. FIGS. 3A to 3C and FIGS. 4A to 4E all show a crystalline state of the seed layers and the pinned layers after heat treatment at a temperature of 400 °C for 5 hours. In the diffraction image of FIG. 4E, a diffraction image of ruthenium (Ru) and a diffraction image of rhenium (Re) are mixed.

Upon comparing the cross-sectional images of FIGS. 3A and 3B with the cross-sectional images of FIGS. 4A, 4B, and 4C, it may be seen that the crystal quality the seed layer of the double layer structure including rhenium (Re)/ruthenium (Ru) and the pinned layer provided thereon has been further improved. In addition, upon comparing the diffraction image of FIG. 3C with the diffraction images of FIGS. 4D and 4E, it may be seen that even after heat treatment at a temperature of 400 °C for 5 hours, the double layer structure including rhenium (Re)/ruthenium (Ru) and the pinned layer provided thereon maintains better crystal quality.

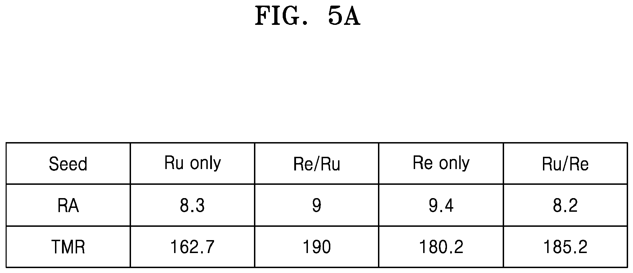

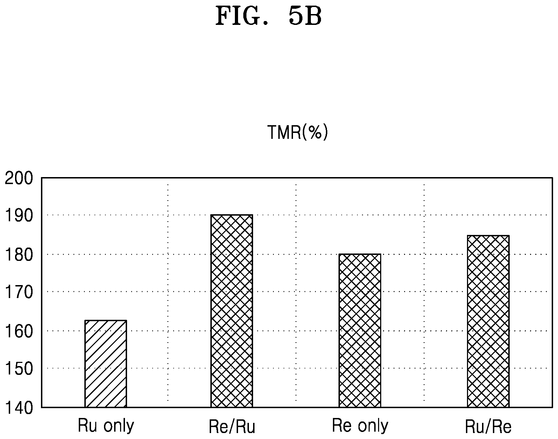

FIGS. 5A and 5B show a comparison of a resistance-area product (RA) and a tunnel magnetoresistance ratio (TMR) of a magnetic tunnel junction device according to the configuration of various seed layers. For example, FIG. 5A is a table showing the RA and TMR of the magnetic tunnel junction device according to the configuration of various seed layers, and FIG. 5B is a graph showing the TMR of the magnetic tunnel junction device according to the configuration of various seed layers shown in FIG. 5A.

Referring to FIG. 5A, an RA value of the magnetic tunnel junction device including a seed layer including only ruthenium (Ru) is about 8.3, and a TMR value thereof is about 162.7 %. An RA value of the magnetic tunnel junction device including a seed layer including only rhenium (Re) is about 9.4, and a TMR value thereof is about 180.2 %. An RA value of the magnetic tunnel junction device including a seed layer of a double layer structure including rhenium (Re)/ruthenium (Ru) is about 9.0, and a TMR value thereof is about 190.0 %. In addition, an RA value of the magnetic tunnel junction device including a seed layer of a double layer structure including ruthenium (Ru)/rhenium (Re) is about 8.2, and a TMR value thereof is about 185.2 %. Therefore, the RA value of the magnetic tunnel junction device including the seed layer including only rhenium (Re) is the greatest, and the RA value of the magnetic tunnel junction device including the seed layer of the double layer structure including rhenium (Re)/ruthenium (Ru) is the next greatest. The RA value of the magnetic tunnel junction device including the seed layer including only ruthenium (Ru) and the RA value of the magnetic tunnel junction device including the seed layer formed of the double layer structure including ruthenium (Ru)/rhenium (Re) may be similar.

Meanwhile, referring to FIGS. 5A and 5B, the TMR value of the magnetic tunnel junction device including the seed layer of a double layer structure including rhenium (Re)/ruthenium (Ru) and the TMR value of the magnetic tunnel junction device including the seed layer of the double layer structure including ruthenium (Ru)/rhenium (Re) are further greater than the TMR value of the magnetic tunnel junction device including the seed layer including only ruthenium (Ru) and the TMR value of the magnetic tunnel junction device including the seed layer including only rhenium (Re).

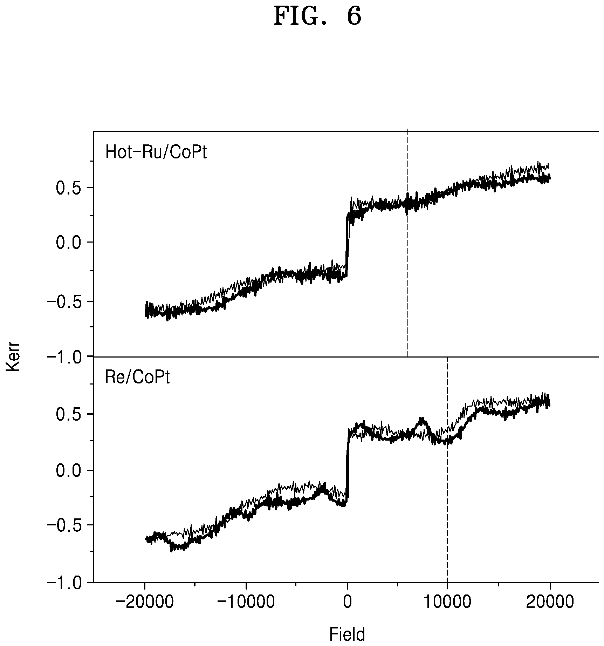

FIG. 6 is a graph for comparing a Kerr rotation angle with respect to an external magnetic field in a pinned layer provided on a seed layer and including only ruthenium (Ru) with a Kerr rotation angle with respect to an external magnetic field in a pinned layer provided on a seed layer and including only rhenium (Re). In FIG. 6, the pinned layer may be a synthetic antiferromagnet (SAF) including two layers of CoPt. Referring to FIG. 6, in the pinned layer provided on the seed layer and including only ruthenium (Ru), deterioration of the pinned layer started at about 6 kOe. When the intensity of the external magnetic field exceeds about 6 kOe, the pinned layer loses the characteristics of a diamagnetic material. On the other hand, the pinned layer provided on the seed layer and including only rhenium (Re) maintained the characteristics of the diamagnetic material up to about 10 kOe. Therefore, the pinned layer provided on the seed layer and including only rhenium (Re) may have a higher exchange coupling field (Hex) and higher stability than the pinned layer provided on the seed layer and including only ruthenium (Ru).

Considering experimental results of FIGS. 2A to 6 described above, when the seed layer 102 includes rhenium (Re), the surface roughness, crystal quality, and/or hex characteristics of the pinned layer 103 may be improved. In addition, it may be seen that the seed layer 102 having the double layer structure including rhenium (Re) may further improve the TMR characteristics of the magnetic tunnel junction device 100 compared to the seed layer including only rhenium (Re). In other words, when rhenium (Re) and ruthenium (Ru) are used together in the double layer structure as the seed layer 102, the magnetic tunnel junction device 100 may show better characteristics compared to when only rhenium (Re) is used alone. Considering this, the seed layer 102 according to some example embodiments may have the double layer structure including rhenium (Re).

For example, as shown in FIG. 1, the seed layer 102 may include a first seed layer 102a provided on the lower electrode 101 and a second seed layer 102b provided on the first seed layer 102a. The pinned layer 103 may be provided on the second seed layer 102b. In other words, the second seed layer 102b may be disposed between the first seed layer 102a and the pinned layer 103. In addition, the pinned layer 103 may directly contact the second seed layer 102b. According to an example embodiment, one of the first seed layer 102a and the second seed layer 102b may include rhenium (Re), and the other may include ruthenium (Ru). For example, the first seed layer 102a may include rhenium (Re) and the second seed layer 102b may include ruthenium (Ru). The first seed layer 102a may include ruthenium (Ru) and the second seed layer 102b may include rhenium (Re).

A total thickness of the seed layer 102 may be, for example, about 1 nm or more and about 10 nm or less. The total thickness of the seed layer 102 may be defined as a distance between a lower surface of the first seed layer 102a contacting the lower electrode 101 and an upper surface of the second seed layer 102b contacting the pinned layer 103. In order to sufficiently obtain the effect of rhenium (Re), a thickness of one of the first seed layer 102a and the second seed layer 102b that includes rhenium (Re) may be 50 % more of the total thickness of the seed layer 102. For example, when the total thickness of the seed layer 102 is 10 nm, the first seed layer 102a includes rhenium (Re), and the second seed layer 102b includes ruthenium (Ru), the thickness of the first seed layer 102a may be 5 nm or more, which is 50 % more of the total thickness of the seed layer 102. When the total thickness of the seed layer 102 is 10 nm, the first seed layer 102a includes ruthenium (Ru), and the second seed layer 102b includes rhenium (Re), the thickness of the second seed layer 102b may be 5 nm or more, which is 50 % more of the total thickness of the seed layer 102.

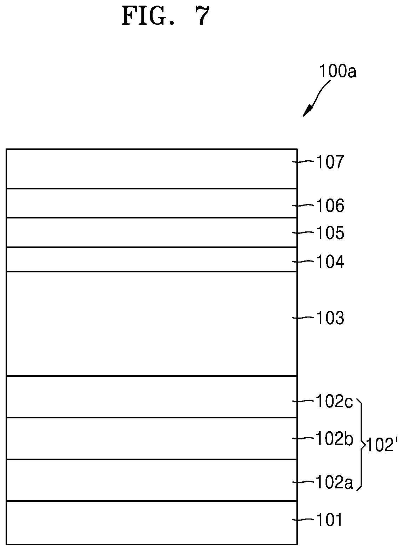

FIG. 7 is a cross-sectional view showing a schematic structure of a magnetic tunnel junction device 100a according to another example embodiment. Referring to FIG. 7, a seed layer 102' of the magnetic tunnel junction device 100a according to another example embodiment may have a multi-layer structure (e.g., a triple layer structure) including rhenium (Re). For example, the seed layer 102' may include a first seed layer 102a provided on the lower electrode 101, the second seed layer 102b provided on the first seed layer 102a, and a third seed layer 102c provided on the second seed layer 102b. The pinned layer 103 may be provided on the third seed layer 102c. In other words, the second seed layer 102b may be disposed between the first seed layer 102a and the third seed layer 102c, and the third seed layer 102c may be disposed between the second seed layer 102b and the pinned layer 103. In addition, the pinned layer 103 may directly contact the third seed layer 102c.

The first seed layer 102a, the second seed layer 102b, and the third seed layer 102c may alternately include rhenium (Re) and ruthenium (Ru). For example, the first seed layer 102a may include rhenium (Re), the second seed layer 102b may include ruthenium (Ru), and the third seed layer 102c may include rhenium (Re). In other words, the seed layer 102' may have a Re/Ru/Re structure. Alternatively, the first seed layer 102a may include ruthenium (Ru), the second seed layer 102b may include rhenium (Re), and the third seed layer 102c may include ruthenium (Ru). In other words, the seed layer 102' may have a Ru/Re/Ru structure.

Even when the seed layer 102' has the triple layer structure, the sum of thicknesses of layers including rhenium (Re) may be 50 % or more of a total thickness of the seed layer 102'. For example, when the seed layer 102' has the Re/Ru/Re structure, the sum of a thickness of the first seed layer 102a and a thickness of the third seed layer 102c may be 50 % or more of the total thickness of the seed layer 102'. When the seed layer 102' has the Ru/Re/Ru structure, the thickness of the second seed layer 102b may be 50 % or more of the total thickness of the seed layer 102'. The total thickness of the seed layer 102' may be defined as a distance between a lower surface of the first seed layer 102a contacting the lower electrode 101 and an upper surface of the third seed layer 102c contacting the pinned layer 103.

FIG. 7 illustrates the seed layer 102' of the triple layer structure, but the disclosure is not limited thereto. For example, the seed layer 102' may have a multi-layer structure of four or more layers. In this case, a layer including rhenium (Re) and a layer including ruthenium (Ru) may be alternately arranged within the seed layer 102'.

The configuration of the magnetic tunnel junction device 100a shown in FIG. 7, excluding the seed layer 102', may be the same as the configuration of the magnetic tunnel junction device 100 shown in FIG. 1. Accordingly, an additional detailed description of the magnetic tunnel junction device 100a shown in FIG. 7 is omitted.

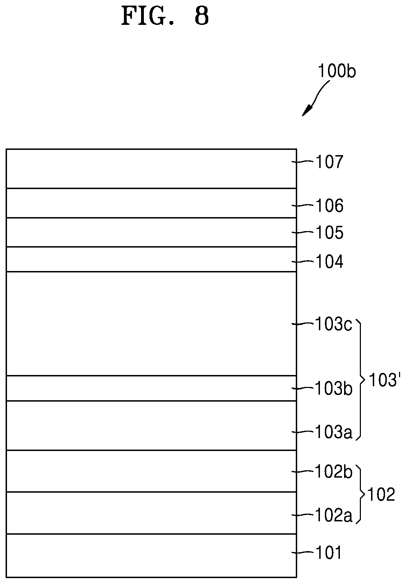

FIG. 8 is a cross-sectional view illustrating a schematic structure of a magnetic tunneling junction device 100b according to another example embodiment. Referring to FIG. 8, a pinned layer 103' of the magnetic tunneling junction device 100b may include an SAF. The pinned layer 103' may include, for example, a first ferromagnetic layer 103a adjacent to the seed layer 102, a second ferromagnetic layer 103c adjacent to the tunnel barrier layer 104, and a SAF coupling layer 103b disposed between the first ferromagnetic layer 103a and the second ferromagnetic layer 103c. In this case, the first ferromagnetic layer 103a, the SAF coupling layer 103b, the second ferromagnetic layer 103c, the tunnel barrier layer 104, and the free layer 105 may be sequentially formed on an upper surface of the seed layer 102.

The SAF coupling layer 103b may include conductive metal. For example, the SAF coupling layer 103b may include at least one of iridium (Ir), ruthenium (Ru), aluminum (Al), copper (Cu), silver (Ag), or an alloy thereof. Each of the first ferromagnetic layer 103a and the second ferromagnetic layer 103c may have a single layer structure including ferromagnetic metal or an alloy of ferromagnetic metal and transition metal, or may also have a multilayer structure including multiple layers including ferromagnetic metal or an alloy of ferromagnetic metal and transition metal. For example, each of the first ferromagnetic layer 103a and the second ferromagnetic layer 103c may include a single layer or multilayer structure including Co, Fe, CoPt, FePt, CoFe, etc.

In such a structure of the pinned layer 103', the first ferromagnetic layer 103a and the second ferromagnetic layer 103c may form an antiferromagnet by Ruderman-Kittel-Kasuya-Yosida (RKKY) interaction by means of the SAF coupling layer 103b. In other words, the pinned layer 103' may have a stable state when a magnetization direction of the first ferromagnetic layer 103a and a magnetization direction of the second ferromagnetic layer 103c are opposite to each other. For example, the first ferromagnetic layer 103a may be magnetized toward a lower surface, and the second ferromagnetic layer 103c may be magnetized toward an upper surface, or the first ferromagnetic layer 103a may be magnetized toward the upper surface, and the second ferromagnetic layer 103c may be magnetized toward the lower surface. The first ferromagnetic layer 103a and the second ferromagnetic layer 103c magnetized in opposite directions may offset stray magnetic fields thereof. Therefore, the first ferromagnetic layer 103a and the second ferromagnetic layer 103c magnetized in opposite directions may be used to reduce or prevent the stray magnetic field generated in the pinned layer 103 from influencing the free layer 105.

FIG. 8 shows that the magnetic tunnel junction device 100b includes the seed layer 102 of the double layer structure, but the magnetic tunnel junction device 100b may also include the seed layer 102' of the triple layer structure shown in FIG. 7. When the magnetic tunnel junction device 100b includes a seed layer 102 of a double layer structure, the first ferromagnetic layer 103a may be formed on the second seed layer 102b. When the magnetic tunnel junction device 100b includes the seed layer 102' having the triple layer structure, the first ferromagnetic layer 103a may be formed on the third seed layer 102c.

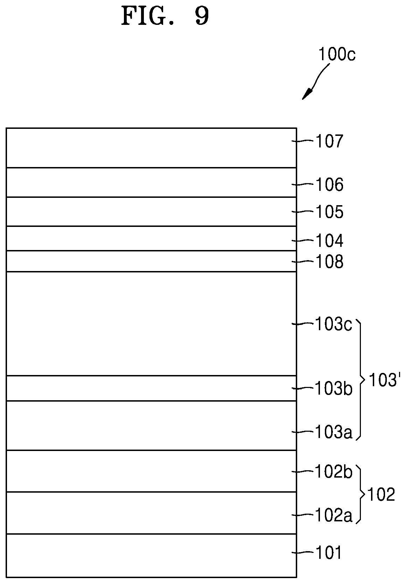

FIG. 9 is a cross-sectional view showing a schematic structure of a magnetic tunnel junction device 100c according to another example embodiment. Referring to FIG. 9, the magnetic tunnel junction device 100c may further include a polarization enhancing layer 108 disposed between the pinned layer 103' and the tunnel barrier layer 104. In this case, the pinned layer 103', the polarization enhancing layer 108, the tunnel barrier layer 104, and the free layer 105 may be sequentially formed on an upper surface of the seed layer 102. The polarization enhancing layer 108 helps the growth of the tunnel barrier layer 104 and the free layer 105 on the pinned layer 103'. In addition, the polarization enhancing layer 108 may have a crystal structure similar to that of the tunnel barrier layer 104 or the free layer 105, and may further improve the crystal quality of the tunnel barrier layer 104 and the free layer 105 formed on the pinned layer 103'. To this end, the polarization enhancing layer 108 may include a ferromagnetic material similar to the free layer 105. For example, the polarization enhancing layer 108 may include at least one of iron (Fe), cobalt (Co), nickel (Ni), manganese (Mn), Fe-containing alloy, Co-containing alloy, Ni-containing alloy, Mn-containing alloy, or Heusler alloy. In addition, the polarization enhancing layer 108 may further include boron. For example, the polarization enhancing layer 108 may include CoFeB. A thickness of the polarization enhancing layer 108 may be about 0.5 nm or more and about 1 nm or less. The polarization enhancing layer 108 may be applied not only to the magnetic tunnel junction device 100c shown in FIG. 9 but also to the magnetic tunnel junction device 100 or 100a shown in FIG. 1 or 7.

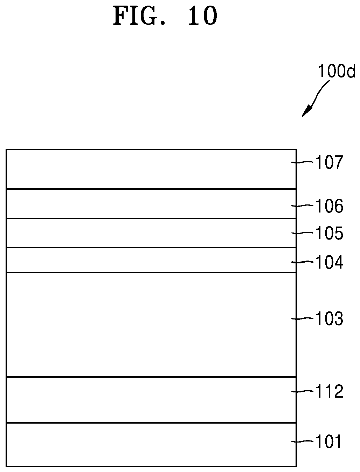

FIG. 10 is a cross-sectional view showing a schematic structure of a magnetic tunnel junction device 100d according to another example embodiment. Referring to FIG. 10, the magnetic tunnel junction device 100d may include the seed layer 112 having a single layer structure including rhenium (Re). The seed layer 112 may include, for example, an alloy including rhenium (Re) in an HCP structure. For example, the rhenium alloy may include an alloy of rhenium and at least one metal of ruthenium (Ru), platinum (Pt), gold (Au), iridium (Ir), or cobalt (Co). According to an example embodiment, a ratio of rhenium (Re) in the seed layer 112 may be 50 at% or more, and a ratio of metal other than rhenium (Re) may be 50 at% or less. For example, the ratio of rhenium (Re) in the seed layer 112 may be between about 50 at% or more and about 90 at% or less, and the ratio of metal other than rhenium (Re) may be between about 50 at% or less and about 10 at% or more.

The seed layer 112 in the single layer structure including the rhenium alloy having an HCP structure may be formed by using a sputtering method. For example, sputtering may be performed by providing argon (Ar) gas and/or krypton (Kr) gas while maintaining the temperature inside a chamber at the room temperature or higher (e.g., about 400 °C or higher) and applying radio frequency (RF) power of a range between about 50 W and about 500 W. A target material may include rhenium (Re) metal and at least one metal among ruthenium (Ru), platinum (Pt), gold (Au), iridium (Ir), or cobalt (Co). At this time, argon (Ar) gas may be provided to the chamber at a flow rate of about 15 standard cc per minute (sccm) or more and 200 sccm or less, and krypton (Kr) gas may be provided to the chamber at a flow rate of about 10 sccm or more and about 100 sccm or less.

The configuration of the magnetic tunnel junction device 100d shown in FIG. 10, excluding the seed layer 112, may be the same as the configuration of the magnetic tunnel junction device 100 shown in FIG. 1. Alternatively, the configuration of the magnetic tunnel junction device 100d shown in FIG. 10, excluding the seed layer 112, may be the same as the configuration of the magnetic tunnel junction device 100b or 100c shown in FIG. 8 or 9.

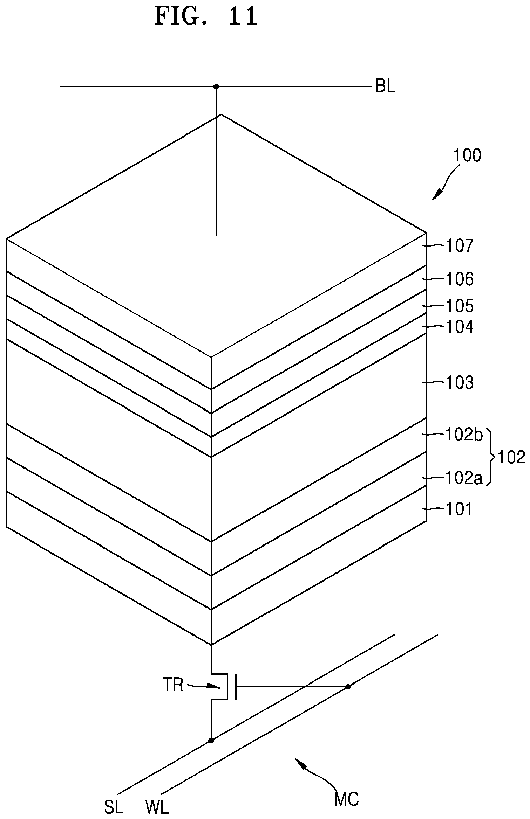

FIG. 11 schematically shows a structure of one memory cell MC including the magnetic tunnel junction device 100 according to an embodiment. Referring to FIG. 11, the memory cell MC may include the above-described magnetic tunnel junction device 100 and a switching device TR connected to the magnetic tunnel junction device 100. The switching device TR may be a thin film transistor. The memory cell MC may be connected between the bit line BL and the word line WL. The bit line BL and the word line WL may be arranged to intersect each other, and the memory cell MC may be arranged at an intersection point of the bit line BL and the word line WL. The bit line BL may be electrically connected to the free layer 105 of the magnetic tunnel junction device 100, and the word line WL may be connected to a gate of the switching device TR. In addition, a drain of the switching device TR may be electrically connected to the lower electrode 101 of the magnetic tunnel junction device 100, and a source of the switching device TR may be electrically connected to the source line SL. In such a structure, a write current, a read current, and an erase current may be applied to the memory cell MC through the word line WL and the bit line BL.

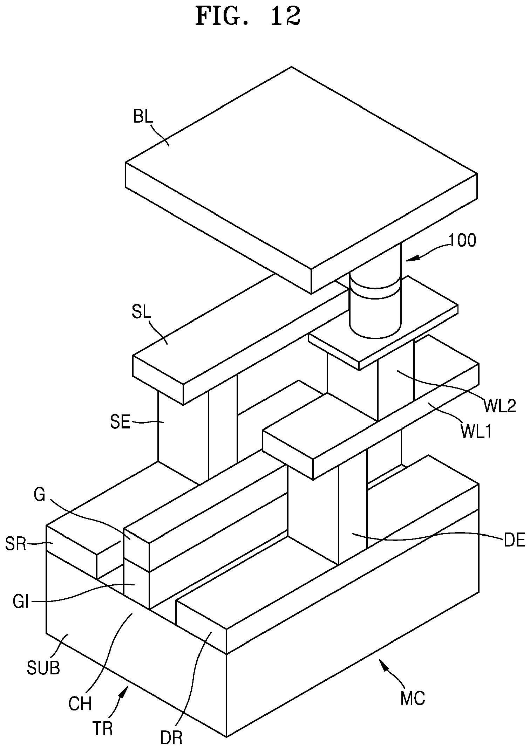

FIG. 12 is a perspective view showing the arrangement structure of the magnetic tunnel junction device 100 and the switching device TR in the memory cell MC shown in FIG. 11. Referring to FIG. 12, the switching device TR may include, for example, a semiconductor substrate SUB, a source region SR, a source electrode SE, a channel CH, a drain region DR, a drain electrode DE, a gate insulating layer Gl, and a gate G. The source electrode SE may be electrically connected to the source line SL, and the drain electrode DE may be electrically connected to the magnetic tunnel junction device 100 through a first wiring WL1 and a second wiring WL2. The first wiring WL1 may extend in a horizontal direction on the same layer as the source line SL, and the second wiring WL2 may extend in a vertical direction between the first wiring WL1 and the magnetic tunnel junction device 100. The bit line BL may be disposed on the magnetic tunnel junction device 100. When the switching device TR is turned on, current may flow from the source line SL to the bit line BL through the source electrode SE, the source region SR, the channel CH, the drain region DR, the drain electrode DE, the first wiring WL1, the second wiring WL2, and the magnetic tunnel junction device 100. The current flowing through the bit line BL may vary depending on the resistance of the magnetic tunnel junction device 100.

In FIG. 12, an empty space between the switching device TR, the source line SL, the first wiring WL1, the second wiring WL2, the magnetic tunnel junction device 100, and the bit line BL may be filled with a passivation layer including a dielectric material of insulating properties. For example, after forming the magnetic tunnel junction device 100 on the first wiring WL1, subsequent processes such as a process of filling the empty space with the dielectric material, a process of forming the bit line BL, a process of filling the dielectric material again on the bit line BL, and a process of forming an additional drive circuit and wirings may be performed. Even when high temperature heat treatment of about 400 °C or higher is performed in such subsequent processes, the pinned layer 103 of the magnetic tunnel junction device 100 according to the above example embodiment may hardly deteriorate.

Meanwhile, FIGS. 11 and 12 show that the memory cell MC includes the magnetic tunnel junction device 100 shown in FIG. 1, but the memory cell MC may also include magnetic tunnel junction devices according to other example embodiments. For example, the memory cell MC may include the magnetic tunnel junction devices 100a, 100b, 100c, and 100d shown in FIGS. 7 to 10.

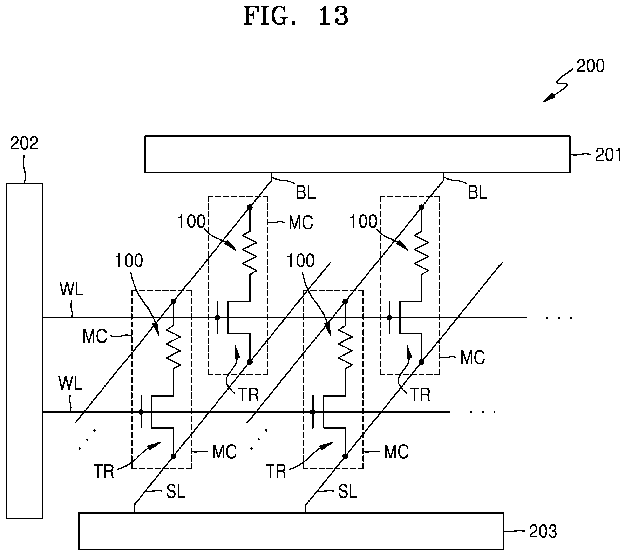

FIG. 13 is a circuit diagram schematically illustrating a configuration of a memory device 200 including a plurality of memory cells MCs. Referring to FIG. 13, the memory device 200 may include a plurality of bit lines BL, a plurality of word lines WL, a plurality of source lines SL, the plurality of memory cells MCs disposed in intersection points of the plurality of bit lines BL and the plurality of word lines WL, respectively, a detection circuit 201 detecting current from the plurality of bit lines BL, a word line driver 202 applying current to the plurality of word lines WL, and a source line driver 203 applying current to the plurality of source lines SL. Each memory cell MC may have the configuration shown in FIGS. 11 and 12. The memory device 200 illustrated in FIG. 13 may be a magnetic random access memory (MRAM), and may be used in electronic devices using nonvolatile memory. For example, the memory device 200 shown in FIG. 13 may be STT-MRAM or SOT-MRAM.

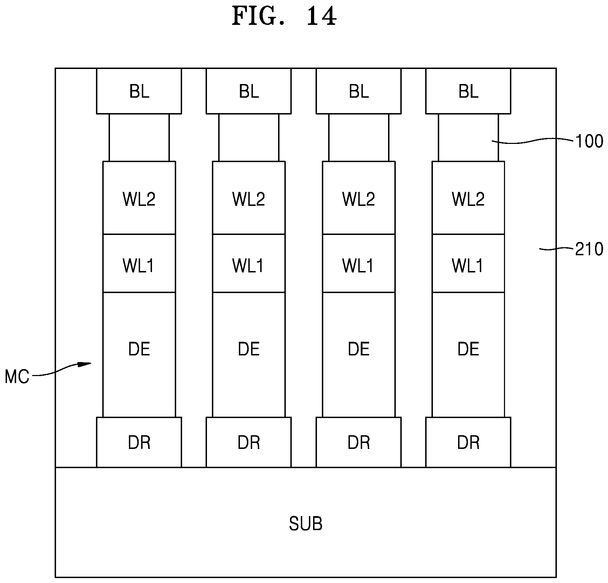

FIG. 14 schematically shows a cross-sectional structure of the plurality of memory cells MCs of the memory device 200 shown in FIG. 13. Referring to FIG. 14, the plurality of memory cells MCs may be arranged on the substrate SUB. In the cross-sectional view of FIG. 14, the plurality of drain regions DR, the plurality of drain electrodes DE, the plurality of first wirings WL1, the plurality of second wirings WL2, the plurality of magnetic tunnel junction devices 100, and the plurality of bit lines BL are illustrated, but other configurations of the memory cell MC may be illustrated in a cross section with a different direction from that of FIG. 14. The memory device 200 may further include a passivation layer 210 filled between the plurality of memory cells MC. As described above, the pinned layer 103 of the magnetic tunnel junction device 100 according to some example embodiments of the disclosure may hardly deteriorate in a subsequent process for forming the passivation layer 210 and the bit line BL.

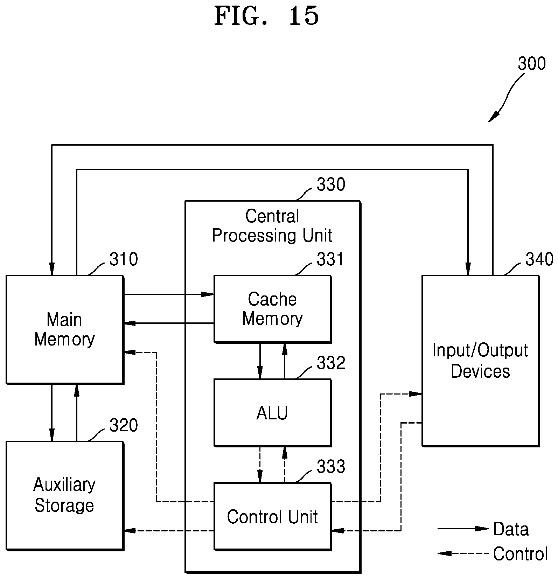

The memory device 200 described above may be used to store data in various electronic devices. FIG. 15 is a conceptual diagram schematically illustrating a device architecture that may be applied to an electronic device 300 according to an example embodiment. Referring to FIG. 15, the electronic device 300 may include a main memory 310, an auxiliary storage 320, a central processing unit (CPU) 330, and an input/output device 340. The CPU 330 may include a cache memory 331, an arithmetic logic unit (ALU) 332, and a control unit 333. The cache memory 331 may include static random access memory (SRAM). The main memory 310 may include a DRAM device, and the auxiliary storage 320 may include the memory device 200 according to the above example embodiments. All of the cache memory 331, the main memory 310, and the auxiliary storage 320 may include the memory device 200 according to the above example embodiments. In some cases, the electronic device 300 may be implemented in a form in which computing unit devices and memory unit devices are adjacent to each other in one chip without distinction between the above-described sub-units.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that some example embodiments described herein should be considered in a descriptive sense only and not for purposes of limitation. Descriptions of features or aspects within the disclosed example embodiments should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A magnetic tunnel junction device comprising:
a seed layer;
a pinned layer on the seed layer;
a free layer facing the pinned layer; and
a tunnel barrier layer between the pinned layer and the free layer,
wherein the seed layer comprises one of:
a single layer comprising rhenium (Re) alloy having a hexagonal close-packed (HCP) structure; and
a multi-layer structure comprising a first seed layer and a second seed layer and the second seed layer is between the first seed layer and the pinned layer, wherein one of the first seed layer and the second seed layer comprises rhenium (Re) and the other of the first seed layer and the second seed layer comprises ruthenium (Ru).

2. The magnetic tunnel junction device of claim 1, wherein the rhenium alloy includes an alloy of rhenium (Re) and at least one metal among ruthenium (Ru), platinum (Pt), gold (Au), iridium (Ir), or cobalt (Co), and optionally wherein a ratio of rhenium (Re) in the seed layer is 50 at% or more and a ratio of the at least one metal is 50 at% or less, and futher optionally wherein a total thickness of the seed layer is 1 nm or more and 10 nm or less.

3. The magnetic tunnel junction device of claim 1, wherein the first seed layer includes rhenium (Re) and the second seed layer includes ruthenium (Ru).

4. The magnetic tunnel junction device of claim 3, wherein a thickness of the first seed layer is 50 % or more of a total thickness of the seed layer.

5. The magnetic tunnel junction device of any one of claims 1, 3 and 4, wherein the first seed layer includes ruthenium (Ru) and the second seed layer includes rhenium (Re).

6. The magnetic tunnel junction device of claim 5, wherein a thickness of the second seed layer is 50 % or more of a total thickness of the seed layer.

7. The magnetic tunnel junction device of any one of claims 1, and 3 to 6, wherein the seed layer further includes a third seed layer between the second seed layer and the pinned layer.

8. The magnetic tunnel junction device of claim 7, wherein the first seed layer includes rhenium (Re), the second seed layer includes ruthenium (Ru), and the third seed layer includes rhenium (Re).

9. The magnetic tunnel junction device of claim 8, wherein a sum of a thickness of the first seed layer and a thickness of the third seed layer is 50 % or more of a total thickness of the seed layer.

10. The magnetic tunnel junction device of claim 7, wherein the first seed layer includes ruthenium (Ru), the second seed layer includes rhenium (Re), and the third seed layer includes ruthenium (Ru).

11. The magnetic tunnel junction device of claim 10, wherein a thickness of the second seed layer is 50 % or more of a total thickness of the seed layer.

12. The magnetic tunnel junction device of any preceding claim, wherein the pinned layer includes a first ferromagnetic layer adjacent to the seed layer, a second ferromagnetic layer adjacent to the tunnel barrier layer, and a synthetic antiferromagnet (SAF) coupling layer between the first ferromagnetic layer and the second ferromagnetic layer, and
magnetization directions of the first ferromagnetic layer and the second ferromagnetic layer are opposite to each other.

13. The magnetic tunnel junction device of claim 12, wherein the SAF coupling layer includes conductive metal.

14. The magnetic tunnel junction device of any preceding claim, further comprising:
a polarization enhancing layer between the pinned layer and the tunnel barrier layer and including a ferromagnetic material.

15. A memory device comprising:
a plurality of memory cells each including the magnetic tunnel junction device of any preceding claim and a switching device connected to the magnetic tunnel junction device.
